# EUROPEAN PATENT APPLICATION

(11) **EP 2 117 052 A2**
(43) Date of publication of application: **11.11.2009**
(21) Application number: 09158834.3
(22) Date of filing: 27.04.2009
(51) Int. Cl.: H01L 31/18

(54) **Semiconductor sheets and methods of fabricating the same**

(30) Priority: 08.05.2008 US 117652
(71) Applicant: General Electric Company, Schenectady, NY 12345 (US)
(72) Inventor: Jonczyk, Ralf, Wilmington, DE 19808 (US); Rand, James, Landenberg, PA 19350 (US)
(74) Representative: Szary, Anne Catherine

(57) **Abstract**

A method of fabricating a sheet of semiconductor material is provided. The method includes forming a first layer (30) of silicon powder that has a lower surface (36) and an opposite upper surface (38). The method also includes depositing a second layer (32) of silicon powder across the upper surface of the first layer, wherein the second layer of silicon powder has a lower surface (44) and an opposite upper surface (46) and has a lower melting point than the first layer (30) of silicon powder. The method also includes heating at least one of the first and second layers of silicon powder to initiate a controlled melt of at least one of the first (30) and second (32) layers of silicon powder, and cooling at least one of the first and second layers of silicon powder to initiate crystallization of at least one of the first (30) and second (32) layers of silicon powder.

## Description

### BACKGROUND OF THE INVENTION

This invention relates generally to semiconductor sheets, and more specifically semiconductor sheets and methods of fabricating the same.

It is known to cut sheets of semiconductor material into wafers of predetermined sizes. Wafers formed of semiconductor materials are used for a variety of applications, and as such, there is an ever-increasing demand for such wafers. For example, at least some known solar-electric systems employ a semiconductor substrate, typically fabricated from silicon (single crystal or polycrystalline). The use of solar-electric systems has increased sharply in the past decade, and as such, the need for semiconductor wafers has also increased in the past decade. Although the expression "solar-electric" is used herein, persons of skill in the art will recognize that the discussion applies to a variety of photovoltaic materials, systems, and phenomena.

A wide variety of fabrication methods are used to produce semiconductor wafers from silicon feedstock. For example, at least some known multicrystalline silicon wafers used in solar cells have been produced by melting a high-purity material to which a dopant, such as phosphorus, boron, gallium, and/or antimony is added, has been added, in an inert atmosphere. The resulting silicon melt is deposited and is cooled to form a multicrystalline ingot. The ingot is then sliced to a desired wafer size. In another fabrication method, a layer of granular silicon is applied to a belt or a setter. The silicon, along with the belt or setter, is then subjected to a thermal sequence to form a silicon wafer or sheet of silicon. The silicon wafer and/or sheet of silicon is then removed from the belt or setter, and is then sized by sawing or scribing.

A significant portion of the cost of such semiconductor wafers is the raw semiconductor material itself. For example, in the case of solar-electric systems, a limiting factor for the use of such systems is the cost of the semiconductor material in the semiconductor wafers (in particular, the cost of the silicon) needed for such systems. Various purities of silicon feedstock are available for use in producing semiconductor wafers. The purity of silicon feedstock is determined by the level of impurities, such as, boron, phosphorus, iron, titanium, and tungsten, that are present in the silicon feedstock. Some applications of semiconductor wafers, for example, high-power electronic devices, require a higher degree of silicon feedstock purity than other applications, for example, solar-electric systems. Because the cost of silicon feedstock increases as the purity of the silicon feedstock increases, the use of solar-electric devices may be limited by the cost of the silicon.

### BRIEF DESCRIPTION OF THE INVENTION

In one embodiment, a method of fabricating a sheet of semiconductor material is described. The method includes forming a first layer of silicon powder that has a lower surface and an opposite upper surface. The method also includes depositing a second layer of silicon powder across the upper surface of the first layer, wherein the second layer of silicon powder has a lower surface and an opposite upper surface and has a lower melting point than the first layer of silicon powder. The method also includes heating at least one of the first and second layers of silicon powder to initiate a controlled melt of one of the first and second layers of silicon powder, and cooling at least one of the first and second layers of silicon powder to initiate crystallization of at least one of the first and second layers of silicon powder.

In another embodiment, a method of fabricating a semiconductor wafer is described. The method includes forming a first layer of silicon powder that has a lower surface and an opposite upper surface. The method also includes depositing a second layer of silicon powder across the upper surface of the first layer, wherein the second layer of silicon powder has a lower surface and an opposite upper surface and has a lower melting point than the first layer of silicon powder. The method also includes heating at least one of the first and second layers of silicon powder to initiate a controlled melt of one of the first and second layers of silicon powder, and cooling at least one of the first and second layers of silicon powder to initiate crystallization of at least one of the first and second layers of silicon powder to form a silicon sheet. The method also includes cutting the silicon sheet to form at least one semiconductor wafer, wherein the at least one semiconductor wafer is sized to facilitate use in a predetermined application.

In another embodiment, a sheet of semiconductor material having a lower surface and an opposite upper surface is described. The sheet of semiconductor material has a higher concentration of metal impurities at the lower surface than any other portion of said sheet. The sheet of semiconductor material is fabricated by a process that includes: forming a first layer of silicon feedstock that has a lower surface and an opposite upper surface; depositing a second layer of silicon feedstock across the upper surface of the first layer, wherein the second layer of silicon feedstock comprises a silicon powder and a metal impurity and has a lower melting point than the first layer of silicon feedstock; heating at least one of the first and second layers of silicon feedstock to initiate a controlled melt of at least one of the first and second layers of silicon feedstock; and cooling at least one of the first and second layers of silicon feedstock to initiate crystallization of at least one of the first and second layers of silicon feedstock. The heating and cooling facilitates segregation of the metal impurity towards the lower surface of the first layer of silicon feedstock.

### BRIEF DESCRIPTION OF THE DRAWINGS

Figure 1 is a schematic diagram of an exemplary apparatus that may be used to fabricate a semiconductor sheet; and
Figures 2-6 are cross-sectional views of a sheet of silicon during subsequent stages of fabrication using the apparatus shown in Figure 1.

### DETAILED DESCRIPTION OF THE INVENTION

Currently, silicon is one of the most commonly used semiconductor materials, also referred to as feedstock, used in the fabrication of semiconductor wafers. Accordingly, as used herein, the terms "semiconductor" and "semiconductor materials" refer to silicon based components and silicon materials. However, as will be readily appreciated by one of ordinary skill in the art, other semiconductor materials in addition to the silicon materials and/or including non-silicon materials can be fabricated using the apparatus and methods described herein. Also, although only the use of silicon powder feedstock is described for use in fabricating a silicon sheet is described herein. Alternatively, crystallized silicon feedstock may be used without deviating from the present invention.

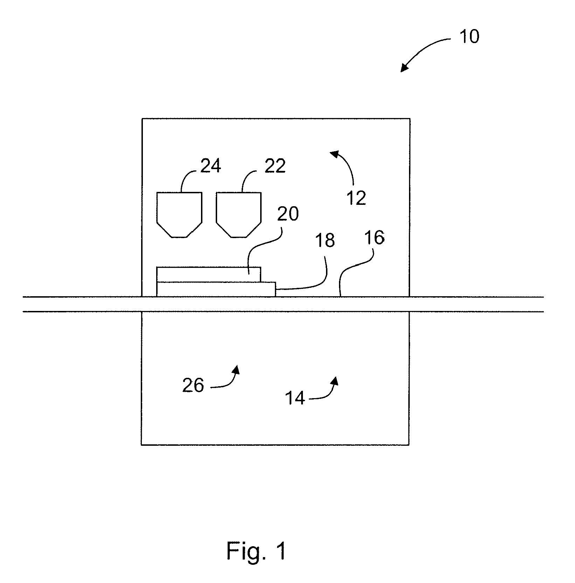

Figure 1 is a schematic diagram of an exemplary apparatus 10 that may be used to fabricate silicon sheets (not shown in Figure 1). In the exemplary embodiment, fabrication apparatus 10 is a controlled-atmosphere furnace that includes a plurality of zones, for example, an upper climate zone 12 and a lower climate zone 14. Zones 12 and 14 operate at different temperature conditions as described in more detail below. Fabrication apparatus 10 also includes a surface 16 that extends between upper climate zone 12 and lower climate zone 14. Surface 16 may be a plate, a conveyor belt, a setter, and/or any other component that facilitates the fabrication of a silicon sheet as described herein.

In an exemplary embodiment, a user positions at least one layer of silicon powder, for example, first layer 18 and/or second layer 20 within fabrication apparatus 10. In an alternative embodiment, wherein surface 16 is a conveyor belt, the conveyor belt passes under a hopper 22 that deposits a desired quantity of silicon powder, together with any desired additives, onto the conveyor belt to create a first layer of silicon powder 18. A second hopper 24 may be used to dispense additional silicon powder onto the conveyor to create a second layer of silicon powder 20.

In the exemplary embodiment, upper climate zone 12 and lower climate zone 14 each include a heat source (not shown in Figure 1). Each heat source provides thermal energy to each respective climate zone 12 and 14. Any heat source may be used that enables fabrication apparatus 10 to function as described herein. In the exemplary embodiment, upper climate zone 12 and lower climate zone 14 each also include a heat extractor (not shown in Figure 1). The heat extractors facilitate removing thermal energy from an object positioned within zones 12 and 14. Any heat extractor may be included that enables fabrication apparatus 10 to function as described herein.

An inert atmosphere is preferably maintained within an interior 26 of fabrication apparatus 10. Specifically, as defined herein, the interior 26 includes upper climate zone 12 and lower climate zone 14. In the exemplary embodiment, the interior 26 of fabrication apparatus 10 is substantially sealed to facilitate preventing the inert materials from escaping from the fabrication apparatus 10 and to prevent contaminants from entering.

Silicon layers 18 and 20 are then subjected to a thermal treatment. For example, upper climate zone 12 and lower climate zone 14 can be independently controlled. As such, each silicon layer 18 and/or 20 can be subjected to an independent thermal treatment such that any desired thermal profile, described in more detail below, can be implemented.

In an exemplary embodiment, the methods described below are performed within fabrication apparatus 10 to fabricate a silicon sheet from silicon feedstock. The two climate zones 12 and 14 facilitate greater control over the thermal energy applied to silicon layers 18 and/or 20. In certain stages described below, it is advantageous to apply a higher magnitude of thermal energy to an upper surface of silicon layer 20 than to a bottom surface of silicon layer 18. In other stages described below, it is advantageous to extract thermal energy from an upper surface of silicon layer 20 while applying thermal energy to a bottom surface of silicon layer 18. Fabrication apparatus 10, and more specifically, the two climate zones 12 and 14 in combination with surface 16, facilitate control over the application and removal of thermal energy to silicon layers 18 and/or 20.

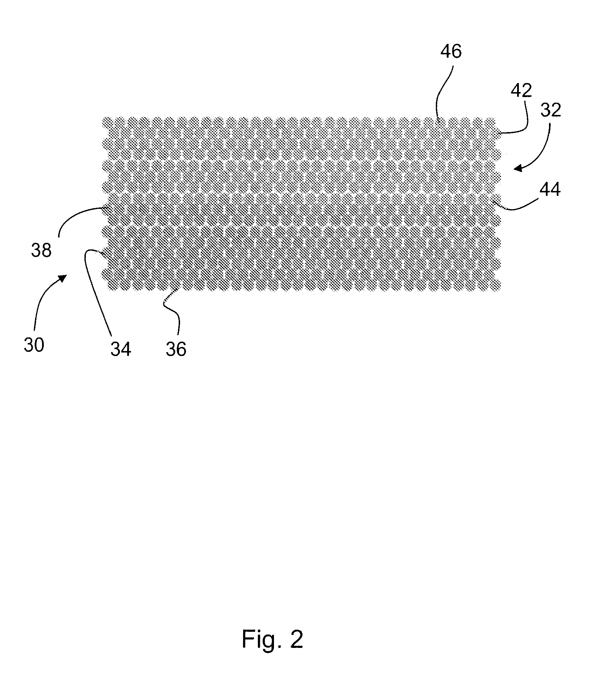

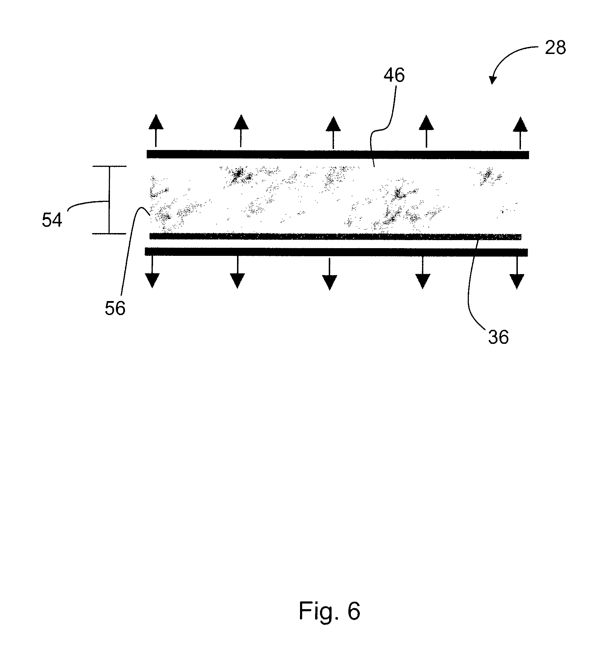

Figures 2-6 are cross-sectional views of semiconductor materials, for example, silicon feedstock, at subsequent stages of fabrication when fabricating a silicon sheet 28 (shown in Figure 6). More specifically, Figure 2 is an exemplary cross-sectional view of a plurality of layers, for example, a first layer 30 and a second layer 32, of different silicon powders. In the exemplary embodiment, first layer 30 of a first silicon powder 34 is deposited across surface 16 (shown in Figure 1). Once deposited, first layer 30 includes a bottom surface 36 and an upper surface 38. Second layer 32 of a second silicon powder 42 is then deposited across first layer upper surface 38. Once deposited, second layer 32 includes a bottom surface 44 and an upper surface 46.

In the exemplary embodiment, first silicon powder 34 and second silicon powder 42 are different. For example, the melting point of either the first powder 34 and/or the second powder 42 is modified, such that the melting points of each powder 34 and 42 are different. More specifically, in the exemplary embodiment, the melting point of second powder 42 is modified through the addition of an impurity (not shown in Figure 2), such as, but not limited to, a metal material. The melting point of second powder 42 may be reduced with the addition of iron and/or copper in second powder 42. The reduced melting point of second layer 32, as compared to first layer 30, facilitates improving the control of the melting and re-crystallization of first and second layers 30 and 32. Although fabrication apparatus 10 facilitates controlled application and removal of thermal energy, the different melting points of first powder 34 and second powder 42 decreases the level of temperature accuracy needed to perform the methods described herein.

Specifically, in the exemplary embodiment, second layer 32 melts into a liquid and re-crystallizes before first layer 30 is liquified. In other words, the dissimilar melting points enable a manufacturer to melt and solidify one layer, i.e., layer 32, of the multiple layers of silicon powder preferentially. In one alternative embodiment, the melting point of one of layers 30 and 32 is modified by oxidizing the silicon powder. In another alternative embodiment, the melting point of one of the layers 30 and/or 32 is modified using any other modification means that enables sheet 28 (shown in Figure 6) to be fabricated as described herein.

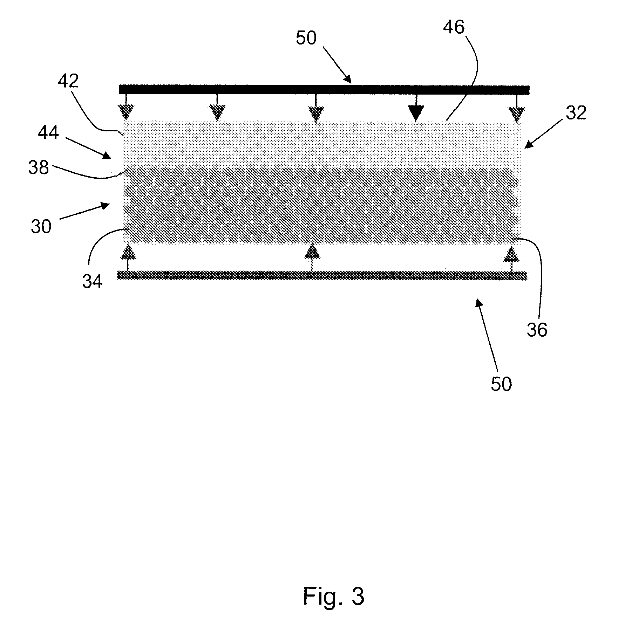

Figure 3 is a cross-sectional diagram of first layer 30 and second layer 32 during a subsequent stage of fabrication in which thermal energy 50 is applied. In the exemplary embodiment, first and second layers 30 and 32 are heated and/or cooled within fabrication apparatus 10 (shown in Figure 1) until second powder 42 melts into a liquid. Specifically, in the exemplary embodiment, a greater amount of thermal energy 50 is applied to upper surface 46 of second layer 32 than is applied to bottom surface 36 of first layer 30. The combination of the reduced melting point of second powder 42 and the increased amount of thermal energy being applied to upper surface 46, causes the second powder 42 to melt before the first powder 34. The liquified second powder 42 seeps at least partially into the first layer 30. In addition, once second powder 42 is liquified, the impurities added to second powder 42 are segregated towards bottom surface 44 and upper surface 38.

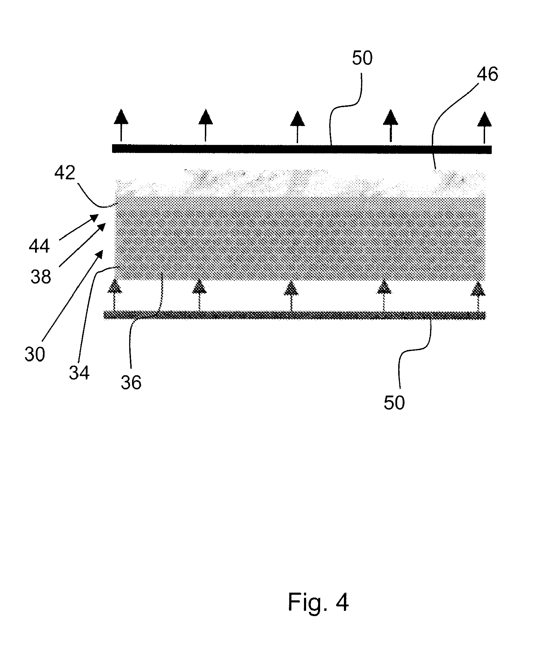

Figure 4 is a cross-sectional diagram of first layer 30 and second layer 32 during a subsequent stage of fabrication in which thermal energy 50 is applied to bottom surface 36 and is removed from upper surface 46. Specifically, in this stage of fabrication, the application of thermal energy 50 to upper surface 46 is discontinued, and the magnitude of thermal energy 50 that is applied to bottom surface 36 is increased. As thermal energy 50 is extracted from upper surface 46, second powder 42 is re-crystallized. The re-crystallized second powder 42 is substantially impurity-free, as the impurities segregate towards bottom surface 44 and upper surface 38.

As the thermal energy 50 applied to bottom surface 36 is increased, first powder 34 begins to melt. As first powder 34 melts, liquified silicon powder 42 mixes with first powder 34. The melting of silicon powder 34 is aided by the impurity-rich liquified silicon powder 42 that has seeped into the upper surface 38 of first powder 34.

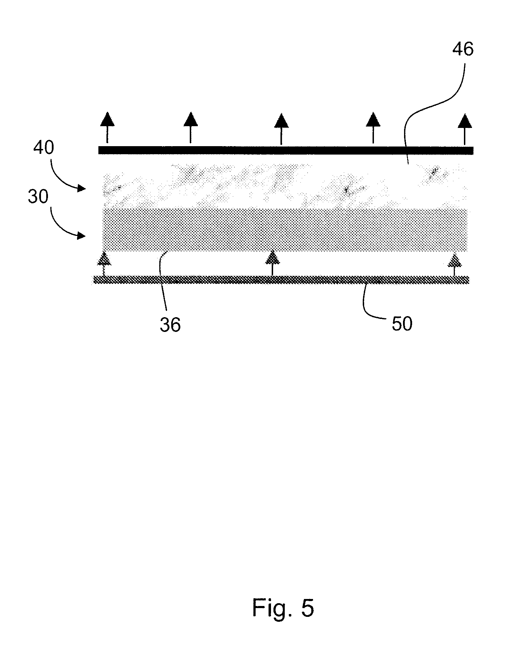

Figure 5 is a cross-sectional diagram of first layer 30 and second layer 32 during a subsequent stage of fabrication in which crystallization continues. Specifically in this stage of fabrication, thermal energy 50 continues to be extracted from upper surface 46, while thermal energy 50 continues to be applied to bottom surface 36. First powder 34 melts into a liquid after the temperature is raised to its melting point. Melting first powder 34 into a liquid enables the impurities formerly present in second powder 42 to segregate towards bottom surface 36. The extraction of thermal energy 50 from upper surface 46 continues to cause crystallization to occur from upper surface 46 towards bottom surface 36.

Figure 6 is a cross-sectional diagram of silicon sheet 28 during a subsequent stage of fabrication. Specifically during this stage of fabrication, the application of thermal energy to bottom surface 36 is discontinued and the extraction of thermal energy from bottom surface 36 is initiated. Crystallization continues from upper surface 46 towards bottom surface 36, and the impurities continue to segregate towards bottom surface 36, leaving a high impurity content at bottom surface 36 of silicon sheet 28. In an example embodiment, bottom surface 36 has an impurity concentration of up to 20% and/or at least 100 parts per million (ppm). Impurities that segregate to bottom surface 36 provide little or no substantial detrimental effect on the performance of solar cells made from silicon wafers produced using the above described methods, so long as a thickness 54 of a first crystallized layer 56 is sufficiently large compared to the minority carrier diffusion length of the first crystallized layer 56. In a manner substantially similar to the description described above of how the impurities segregate towards bottom surface 36, other impurities present in first powder 34 and second powder 42, such as, but not limited to, boron, phosphorus, titanium, and tungsten, also segregate towards bottom surface 36 as first powder 34 and second powder 42 are melted and re-crystallized as described above.

The process and apparatus described above enable the fabrication of a silicon sheet from multiple layers of silicon powder, which are modified to have slightly dissimilar melting points, by melting the deposited silicon layers in a controlled-atmosphere furnace. The different melting points of the multiple layers of silicon powder facilitates enhanced control of melting locally and the melting and partial re-crystallization of one silicon layer before a different silicon layer is melted. More specifically, in the exemplary embodiment, a layer of silicon powder having a lower melting point is spread across a layer of silicon powder having a higher melting point. When thermal energy is applied to the layers of silicon powder from above the layers, the upper layer melts first, seeps partially into the bottom layer, and then re-crystallizes from the top when the heat is extracted from above the layers.

As the upper layer melts, impurities in the layer segregate towards the bottom of the wafer and the upper layer of silicon crystallizes from the top, leaving upper layer of silicon substantially impurity-free. Thermal energy is then applied to the layers from beneath the layers. The bottom layer of silicon, which includes its own impurities and those segregated from the upper layer, melts into a liquid, which enables impurities to segregate towards the bottom of the wafer. Because the thermal energy is removed from above the layers, crystallization continues from top to bottom, segregating the impurities further towards the bottom of the wafer.

By melting the layers of silicon powder in different fabrication stages, limitations posed by the high surface tension of silicon are mitigated, such that a thinner wafer from a powder layer that may not otherwise be possible may be produced. In the exemplary embodiment, the layers of silicon powder are heated, initially from above, followed by heat extraction and heating from below. Effects from surface tension are avoided by maintaining part of the silicon sheet as a solid throughout the process. Also, the presence of impurities used to modify the melting point of the upper layer of silicon assists the segregation of other undesirable impurities such as, but not limited to, Titanium, Tungsten, and Chromium. This is highly beneficial since silicon feedstock with boron and phosphorous content is more readily available and lower in cost when compared to substantially pure silicon.

The above-described methods and apparatus provide a cost-effective and reliable means to facilitate the production of thin silicon sheets from low cost powdered silicon feedstock. The addition of an impurity reduces the melting point of one layer of silicon feedstock. Having multiple layers of silicon that each has a different melting point, allows melting and partial re-crystallization of one silicon layer before other silicon layers are melted. By controlling the application and removal of thermal energy, the added impurities, along with any other impurities present in the silicon feedstock, segregate towards a bottom of the silicon sheet where the impurities have substantially no detrimental effect on the performance of solar cells made from silicon sheets produced. Furthermore, as the impurities segregate towards the bottom of the silicon sheet, the top of the silicon sheet is left substantially free of the impurities. As a result, a substantially pure silicon sheet is produced in a cost-effective manner.

Exemplary embodiments of a process and apparatus for forming a sheet of silicon using two chemically different layers of powders spread prior to melting is described above in detail. The process and apparatus are not limited to the specific embodiments described herein, but rather, steps of the process and components of the apparatus may be utilized independently and separately from other steps and components described herein.

## Claims

1. A method of fabricating a sheet of semiconductor material, said method comprising:
forming a first layer (18,30) of silicon powder that has a lower surface (36) and an opposite upper surface (38);
depositing a second layer (20,32) of silicon powder across the upper surface of the first layer, wherein the second layer of silicon powder has a lower surface (44) and an opposite upper surface (46) and has a lower melting point than the first layer of silicon powder;
heating at least one of the first and second layers of silicon powder to initiate a controlled melt of at least one of the first and second layers of silicon powder; and
cooling at least one of the first and second layers of silicon powder to initiate crystallization of at least one of the first and second layers of silicon powder.

2. A method according to claim 1, wherein depositing a second layer (20,32) of silicon powder further comprises adding an impurity to the second layer of silicon powder to facilitate reducing the melting point of the second layer of silicon powder as compared to the first layer of silicon powder (18,30).

3. A method according to claim 2, wherein adding an impurity to the second layer (20,32) of silicon powder comprises adding at least one of iron and copper to the silicon powder.

4. A method according to any preceding claim, wherein heating at least one of the first and second layers (18,20,30,32) comprises applying heat to the upper surface (46) of the second layer of silicon powder to cause the second layer of silicon powder to melt.

5. A method according to claim 4, wherein heating at least one of the first and second layers (18,20,30,32) further comprises applying heat to the lower surface (36) of the first layer of silicon powder such that a temperature at the lower surface of the first layer is lower than a temperature at the upper surface (46) of the second layer.

6. A method according to any preceding claim, further comprising determining when the second layer (20,32) of silicon powder has liquified.

7. A method according to claim 6, further comprising discontinuing heating of the upper surface (46) of the second layer (20,32) of silicon powder after determining that the second layer of silicon powder has liquified.

8. A method according to claim 6, further comprising increasing the magnitude of heat applied to the lower surface (36) of the first layer (18,30) of silicon powder after determining that the second layer (32) of silicon powder has liquified.

9. A method according to claim 6, wherein cooling at least one of the first and second layers (30,32) comprises extracting heat from the upper surface (46) of the second layer of silicon powder to initiate crystallization of at least a portion of the second layer of silicon powder after determining that the second layer of silicon powder has melted.

10. A method according to claim 9, wherein extracting heat comprises applying a heat extractor to at least one of the upper surface (46) of the second layer (32) and the lower surface (36) of the first layer (18,30).

11. A method of fabricating a semiconductor wafer, said method comprising:
forming a first layer (18,30) of silicon powder that has a lower surface (36) and an opposite upper surface (38);
depositing a second layer (20, 32) of silicon powder across the upper surface of the first layer, wherein the second layer of silicon powder has a lower surface (44) and an opposite upper surface (46) and has a lower melting point than the first layer of silicon powder;
heating at least one of the first and second layers of silicon powder to initiate a controlled melt of one of the first and second layers of silicon powder;
cooling at least one of the first and second layers of silicon powder to initiate crystallization of at least one of the first and second layers of silicon powder to form a silicon sheet; and
cutting the silicon sheet to form at least one semiconductor wafer, wherein the at least one semiconductor wafer is sized to facilitate use in a predetermined application.

12. A method according to claim 11, wherein depositing a second layer (20,32) of silicon powder further comprises adding an impurity to the second layer of silicon powder to facilitate reducing the melting point of the second layer of silicon powder as compared to the first layer of silicon powder (18,30).

13. A method according to claim 12, wherein adding an impurity to the second layer (20, 32) of silicon powder comprises adding at least one of iron and copper to the silicon powder.

14. A method according to claim 11, wherein heating at least one of the first (18,30) and second (20,32) layers comprises applying heat to the upper surface (46) of the second layer of silicon powder to cause the second layer of silicon powder to melt.

15. A sheet of semiconductor material having a lower surface and an opposite upper surface, said sheet of semiconductor material having a higher concentration of metal impurities at the lower surface than any other portion of said sheet, said sheet of semiconductor material fabricated by a process comprising:
forming a first layer of silicon feedstock that has a lower surface and an opposite upper surface;
depositing a second layer of silicon feedstock across the upper surface of said first layer, wherein said second layer of silicon feedstock comprises a silicon powder and a metal impurity and has a lower melting point than said first layer of silicon feedstock;
heating at least one of said first and second layers of silicon feedstock to initiate a controlled melt of at least one of said first and second layers of silicon feedstock; and
cooling at least one of said first and second layers of silicon feedstock to initiate crystallization of at least one of said first and second layers of silicon feedstock, wherein the heating and the cooling facilitates segregation of said metal impurity towards the lower surface of said first layer of silicon feedstock.
